# EUROPEAN PATENT SPECIFICATION

(11) **EP 2 738 821 B1**
(45) Date of publication and mention of the grant of the patent: **21.02.2018**
(21) Application number: 12820545.7
(22) Date of filing: 21.03.2012
(51) Int. Cl.: H01L 31/042

(54) **PHOTOVOLTAIC MODULE**
PV-MODUL
MODULE DE PUISSANCE PHOTOVOLTAÏQUE

(30) Priority: 29.07.2011 JP 2011166582
(43) Date of publication of application: 04.06.2014
(73) Proprietor: Panasonic Intellectual Property Management Co., Ltd., Osaka-shi, Osaka 540-6207 (JP)
(72) Inventor: YOSHIMINE, Yukihiro, Chuo-ku, Osaka 540-6207 (JP); ISHIGURO, Tasuku, Chuo-ku, Osaka 540-6207 (JP)
(74) Representative: Klunker IP Patentanwälte PartG mbB
(86) International application number: PCT/JP2012/057175
(87) International publication number: WO 2013/018395

(56) References cited:
- WO-A1-2012/029847
- JP-A- 2001 332 750
- JP-A- 2007 141 967
- JP-A- 2009 231 387
- JP-A- 2010 275 415
- JP-A- 2011 119 475
- US-A1- 2009 235 980
- US-A1- 2009 314 343

## Description

### TECHNICAL FIELD

The present invention relates to a photovoltaic module.

### BACKGROUND ART

Typically, a photovoltaic module includes a first protective member to protect the light-receiving surface side of a photovoltaic element, and a second protective member to protect the back surface side of the photovoltaic element. Then, between the protective members, there is provided a sealing member to seal the photovoltaic element. As the sealing member, there has been used a crosslinking resin whose primary component is ethylene-vinyl acetate copolymer (EVA) or the like, which exhibits a good adhesion to the photovoltaic element.

Also, in recent years, there has been proposed a number of modules that use a non-crosslinking resin as the sealing member. For example, JP H10-341030 A discloses a solar cell module that uses a sealing member composed of a non-crosslinking resin and a crosslinking resin. The document discloses a configuration in which a crosslinking resin layer is provided on at least one surface of a non-crosslinking resin layer, and the crosslinking resin layer covers the whole of the light-receiving surface of the photovoltaic element.

US 2009/314343 A1 discloses a photovoltaic (PV) module in which an encapsulant is permitted to be a first layer, wherein a cover glass and the encapsulant are considered optically equivalent, since their refractive indexes are substantially the same, a light trapping film to be a second layer, an anti-reflective layer to be a third layer, and an n-type layer to be a fourth layer, wherein the light trapping film, i.e., one layer among the light transmitting layers, has a structured shape on an incident side where incident light enters.

### SUMMARY OF INVENTION

### TECHNICAL PROBLEM

Incidentally, in order to suppress the surface reflection of incident light and increase the amount of light absorption, for example, a pyramidal textured structure is formed on the light-receiving surface of the photovoltaic element. Furthermore, on the light-receiving surface, there are also concavities and convexities by a light-receiving surface electrode such as a finger electrode. These concavo-convex surface structures greatly affect the adhesion to the sealing member, and can cause a decrease in the adhesion.

### SOLUTION TO PROBLEM

The present invention provides a photovoltaic module with the features according to claim 1. Further embodiments are defined in the dependent claims.

### ADVANTAGEOUS EFFECT OF INVENTION

A photovoltaic module according to the present invention may increase photoelectric conversion efficiency.

### BRIEF DESCRIPTION OF DRAWINGS

In the following detailed description given hereafter and the accompanying drawings, examples are not according to but for a better understanding of the invention and embodiments are according to the invention.
FIG. 1 is a diagram of a photovoltaic module according to an embodiment of the present invention, viewed from the light-receiving surface side.
FIG. 2 is a diagram schematically showing a cross-section taken along line A-A in FIG. 1.
FIG. 3 is an enlarged diagram of part B in FIG. 2 and a diagram showing an exemplary configuration of a sealing member according to an example not part of the invention.
FIG. 4 is an enlarged diagram of part B in FIG. 2 and a diagram showing a configuration of the sealing member according to an embodiment.
FIG. 5 is a diagram showing a relationship between a thickness of a finger electrode and a width around the finger electrode in which interfacial peeling is likely to occur.
FIG. 6 is a diagram showing a modification of the photovoltaic module according to the embodiment of the present invention.

### DESCRIPTION OF EXAMPLES AND EMBODIMENTS

A photovoltaic module 10 according to an embodiment of the present invention will be described in detail with reference to the drawings.

The present invention is not limited to the following embodiment. The reference drawings in the embodiment are schematically illustrated, and in some cases, the dimensional ratios and others of constituent elements drawn in the drawings are different from those of an actual thing. Concrete dimensional ratios and others should be judged in consideration of the following descriptions.

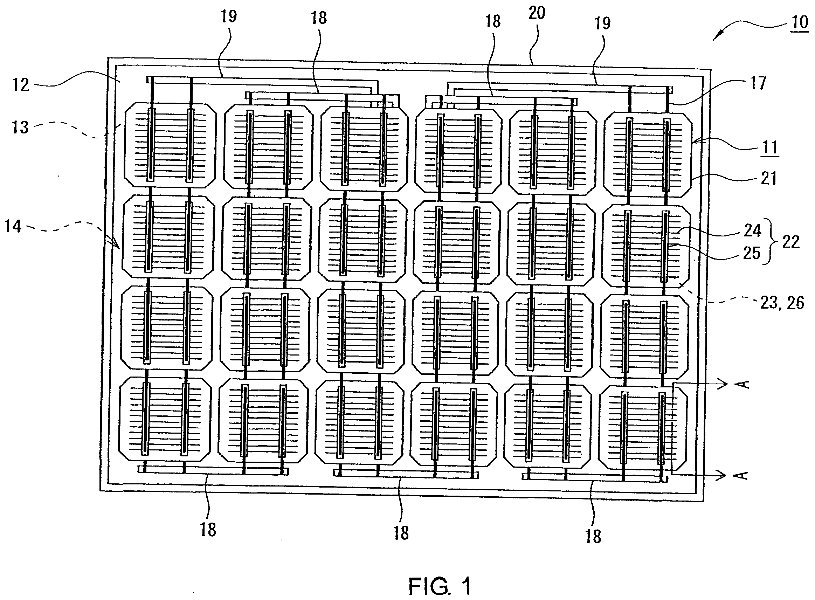

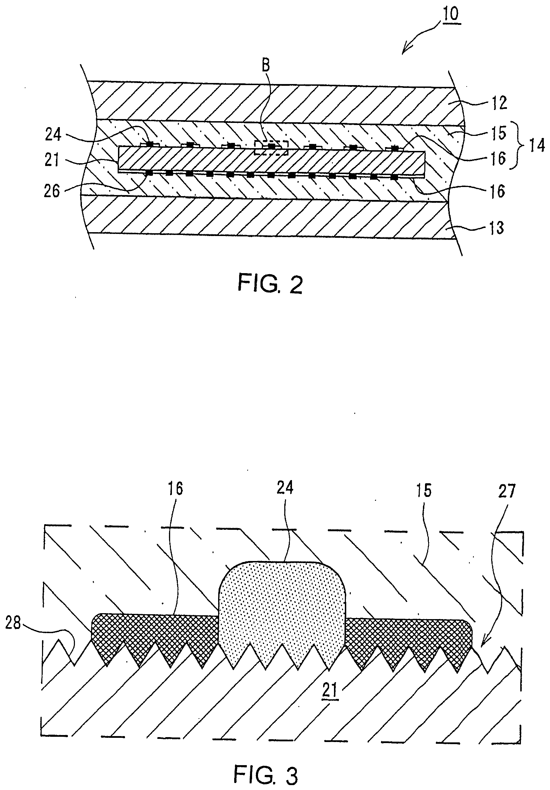

FIG. 1 is a plan diagram of the photovoltaic module 10, viewed from the light-receiving surface side, and FIG. 2 is a cross-sectional diagram taken along line A-A in FIG. 1 (a textured structure 27 is omitted).

The photovoltaic module 10 includes a plurality of photovoltaic elements 11, a first protective member 12 disposed on the light-receiving surface sides of the photovoltaic elements 11, and a second protective member 13 disposed on the back surface sides of the photovoltaic elements 11. That is, the photovoltaic element 11 is sandwiched by the first protective member 12 and the second protective member 13.

As the first protective member 12, it is possible to use a transparent plate body or film, for example, a member having transparency such as a glass plate, a resin plate or a resin film. As the second protective member 13, it is possible to use a glass plate, a resin plate, a resin film or the like similar to the first protective member 12. Here, in the case of not intending to receive light from the back surface side, the second protective member 13 may be an opaque plate body or film, for example, or may be a multilayered film such as resin films sandwiching an aluminum foil or the like.

A sealing member 14 is respectively filled into between the photovoltaic element 11 and the first protective member 12, between the photovoltaic element 11 and the second protective member 13, and between the photovoltaic elements 11 that are adjacent. That is, the photovoltaic element 11 is sealed by the sealing member 14. The sealing member 14, which will be described in detail later, is configured to include a first resin 15 and a second resin 16.

The photovoltaic module 10 further includes tabs 17 that are wiring members for electrically connecting the photovoltaic elements 11, crossover tabs 18 for connecting the tabs 17 to each other, and output tabs 19 for bringing out an output power to the exterior. Furthermore, the photovoltaic module 10 may include a frame 20 that is attached to the edges of the first protective member 12 and the second protective member 13, and a terminal box, not shown in the figure, that is attached on the surface of the second protective member 13. In the photovoltaic module 10, the plurality of photovoltaic elements 11 are arranged such that the light-receiving surfaces are each arrayed on the same plane.

Here, the "light-receiving surface" means a surface to which light principally enters from the exterior of the photovoltaic element 11. For example, over 50% to 100% of the light to enter the photovoltaic element 11 enters it from the light-receiving surface side. The "back surface" means a surface on the side opposite to the light-receiving surface.

The photovoltaic element 11 includes a photovoltaic portion 21 to generate carriers (electrons and holes) by receiving light such as sunlight, a light-receiving surface electrode 22 provided on the light-receiving surface of the photovoltaic portion 21, and a back surface electrode 23 provided on the back surface of the photovoltaic portion 21. In the photovoltaic element 11, the carriers generated in the photovoltaic portion 21 are collected by the light-receiving surface electrode 22 and the back surface electrode 23. The light-receiving surface electrode 22 and the back surface electrode 23 are composed of metal. Preferably, the area of the light-receiving surface electrode 22 should be smaller than that of the back surface electrode 23, in order to decrease loss by light shielding.

The photovoltaic portion 21 has a substrate composed of a semiconductor material such as crystalline silicon, gallium arsenide (GaAs) or indium phosphide (InP), for example. The structure of the photovoltaic portion 21 is not particularly limited, and the embodiment exemplifies a structure having a hetero-junction between an n-type monocrystal silicon substrate and an amorphous silicon. For example, the photovoltaic portion 21 has, on the light-receiving surface of the n-type monocrystal silicon substrate, an i-type amorphous silicon layer, a p-type amorphous silicon layer in which boron (B) or the like is doped, and a transparent conductive layer composed of a translucent conductive oxide such as indium oxide, in this order. In addition, it has, on the back surface of the substrate, an i-type amorphous silicon layer, an n-type amorphous silicon layer in which phosphorus (P) or the like is doped, and a transparent conductive layer, in this order.

The light-receiving surface electrode 22 is configured to include a plurality of (for example, 50) finger portions 24 and a plurality of (for example, two) bus bar portions 25.

The finger portions 24 and the bus bar portions 25, which are electrode portions in a fine wire shape, are arranged so as to intersect each other and are electrically connected. The finger portions 24 and the bus bar portions 25 are formed, for example, by screenprinting a conductive paste in which conductive fillers such as silver (Ag) are dispersed in a binder resin, on the transparent conductive layer in a desired pattern.

The finger portions 24 are electrode portions that collect carriers uniformly from the whole of the photovoltaic portion 21. The finger portions 24 are arranged parallel to each other on nearly the whole of the light-receiving surface, at predetermined intervals (for example, 1.5 mm to 3 mm). Preferably, the width of the finger portion 24 should be approximately 50 µm to 150 µm, and preferably, the thickness thereof should be approximately 20 µm to 80 µm.

The bus bar portions 25 are electrode portions to which the tabs 17 are electrically connected through a non-conductive adhesive or a conductive adhesive. The bus bar portions 25 are arranged parallel to each other at predetermined intervals. The bus bar portions 25 electrically collect carriers principally from the finger portions 24, and transmit them to the tabs 17. Preferably, the width of the bus bar portion 25 should be approximately 1.5 mm to 3 mm, and preferably, the thickness thereof should be approximately 20 µm to 160 µm.

Similarly to the light-receiving surface electrode 22, it is preferable that the back surface electrode 23 be configured to include a plurality of finger portions 26 and a plurality of bus bar portions (not shown in the figure). The finger portions 26 may be set such that the number thereof is more and the interval thereof is less, compared to the finger portions 24 (for example, number: 250, interval: 0.5 mm). Here, in the case of not intending to receive light from the back surface side, the back surface electrode 23 may be a metal film such as a silver (Ag) thin film, which is formed on nearly the whole of the back surface of the photovoltaic portion.

In the embodiment, each tab 17 connects the adjacently arranged photovoltaic elements 11 to each other. One end of the tab 17 is connected to the light-receiving surface electrode 22 of one photovoltaic element 11 of the adjacently arranged photovoltaic elements 11. The other end of the tab 17 is connected to the back surface electrode 23 of the other photovoltaic element 11. That is, the tab 17 is bent between the adjacent photovoltaic elements 11 in the thickness direction of the photovoltaic module 10, and connects the adjacent photovoltaic elements 11 in series.

Next, the surface structure of the photovoltaic element 11 and the sealing member 14 will be described in detail, with further reference to FIGS. 3 to 5.

FIG. 3 is an enlarged diagram of part B in FIG. 2, that is, an enlarged diagram of the vicinity of the finger portion 24.

The light-receiving surface of the photovoltaic portion 21 has a textured structure 27. Here, the textured structure is a concavo-convex surface structure that suppresses surface reflection and increases the amount of light absorption of the photovoltaic portion 21. As a concrete example of the textured structure, it is possible to exemplify a concavo-convex structure in a pyramid shape (a square pyramid shape or a truncated pyramid shape) that is obtained by performing anisotropic etching on the light-receiving surface of a substrate composed of a monocrystal silicon with a (100) plane. Also, it is possible to exemplify a concavo-convex structure that is obtained by performing isotropic etching to the light-receiving surface of a substrate composed of a crystal semiconductor material such as a monocrystal silicon or a polycrystal silicon. Here, preferably, the textured structure 27 should also be provided on the back surface of the photovoltaic portion 21.

Preferably, the height of the concavities and convexities of the textured structure 27, that is, the depth of the concavities 28, should be approximately 1 µm to 15 µm, particularly, approximately 5 µm to 10 µm. Since the thickness of the i-type amorphous silicon layer, p-type amorphous silicon layer and transparent conductive layer, which are formed on the light-receiving surface of the substrate containing an n-type monocrystal silicon, is approximately several nm to several tens of nm, the textured structure 27 reflects the surface shape of the n-type monocrystal silicon substrate.

The sealing member 14 is disposed on the light-receiving surface of the photovoltaic element 11 so as to contact with the light-receiving surface. The sealing member 14 adheres tightly to the photovoltaic element 11 without a break and seals the photovoltaic element 11, such that moisture and the like do not act to the photovoltaic element 11. For increasing the adhesion to the photovoltaic element 11, in addition to a first resin 15 that is the primary component, the sealing member 14 includes a second resin 16 that has a higher adhesion strength to the photovoltaic element 11 than the first resin 15.

The first resin 15 is a resin that has a higher hydrophobic property than the second resin 16. In other words, the second resin 16 is a resin that has a higher hydrophilic property than the first resin 15. That is, since the first resin 15 with a high hydrophobic property is the primary component, it is possible to suppress a decrease in reliability by a moisture containing. On the other hand, the second resin 16, which has a higher hydrophilic property than the first resin 15, is provided at a part between the photovoltaic element 11 and the first resin 15.

Here, when the photovoltaic element 11 has a metallic oxide layer such as a transparent conductive layer on the surface, since the surface is hydrophilic, the providing of the second resin 16 improves the adhesion between the photovoltaic element 11 and the first resin 15. Also, when the surface of the photovoltaic element 11 is a surface of a crystal silicon substrate, the surface of the substrate often becomes hydrophilic by adherence of impurities such as organic matter in the atmosphere. In this case also, the providing of the second resin 16 improves the adhesion between the photovoltaic element 11 and the first resin 15.

Here, the degree of the hydrophobic and hydrophilic properties of a resin can be shown by, for example, the solubility parameter (SP value), the contact angle of water, or the moisture content. Preferably, the SP value of the first resin 15 should be, for example, less than 9.0, particularly, approximately 7.5 to 8.5. Preferably, the SP value of the second resin 16 should be 9.0 or more, particularly, approximately 9.5 to 14.0. That is, it can be said that the first resin 15 is a resin that has a lower SP value than the second resin 16.

Preferably, the second resin 16 should have a higher softening temperature than the first resin 15. The "softening temperature" is defined as a temperature at which, when a constant load is applied to a test sample, a predetermined deformation occurs. In terms of productivity, preferably, the first resin 15 should be a thermoplastic resin that melts at a low temperature, for example, melts at a temperature of approximately 80°C to 170°C, more preferably, approximately 85°C to 130°C. On the other hand, for maintaining the adhesion between the photovoltaic element 11 and the sealing member 14 under a high-temperature environment, preferably, the second resin 16 should be a thermoplastic resin that has a higher melting point than the first resin 15, or a thermosetting resin that does not melt by heat. In terms of productivity, it is particularly preferable that the second resin 16 be a curing resin that hardens by a crosslinking reaction with heat, ultraviolet rays (UV), electron rays (EV), humidity, a crosslinking agent, or the like.

Here, preferably, the first resin 15 should be a slightly-crosslinking resin with a gel fraction of less than 10%, or a non-crosslinking resin with a gel fraction of 0% (including nearly 0%). It is particularly preferable to be a non-crosslinking resin. On the other hand, preferably, the second resin 16 should be a crosslinking resin with a gel fraction of 50% or more, particularly, a crosslinking resin with a gel fraction of 80% or more. The gel fraction is calculated by (weight of dried non-dissolved-part / weight of test sample) × 100 (%), after immersing a ground test sample in toluene for seven days (room temperature condition), separating the in-toluene non-dissolved-part from the toluene and the in-toluene dissolved-part, and drying it.

Concrete examples of the first resin 15 include a polyolefin resin (for example, polyethylene (PE), polypropylene (PP), a random or block copolymer of PE and PP) that is obtained by polymerizing at least one kind selected from 2-20C α-olefin.

Concrete examples of the second resin 16 include a polyester resin (for example, a polycondensate of polyol and polycarboxylic acid or acid anhydride thereof-lower alkyl ester), a polyurethane resin (a polyaddition compound of polyisocyanate and an active hydrogen group-containing compound (diol, polyol, dicarboxylic acid, polycarboxylic acid, polyamine, polythiol, or the like)), an epoxy resin (for example, a ring-opening polymer of polyepoxide, or a polyaddition compound of polyepoxide and the above active hydrogen group-containing compound), an acrylic resin, a polyamide resin, a polyimide resin, a phenol resin, a copolymer (for example, EVA) of α-olefin and carboxylic acid vinyl, acrylic ester or other vinyl monomers, and a mixed resin thereof. Preferably, these should have a higher softening temperature than the first resin 15, and be crosslinkable. For example, in the case of using EVA, it is preferable to use an organic peroxide as a crosslinking agent. Furthermore, it is preferable to lower the internal stress by combining a silicone resin, an elastomer or the like with these resins. Here, the presence or absence of these resins can be checked based on the peak wavelength of a spectrum obtained by the microscopic ATR method (a total reflection absorption method using an infrared microscopic apparatus).

As the second resin 16, it is preferable to use a curing resin that is a low viscosity liquid in an uncured state. Alternatively, it is preferable to use a curing resin that has a high solubility in an organic solvent and provides a low viscosity resin solution. The viscosity of the uncured resin or uncured resin solution should be preferably less than 20 Pa.s, more preferably less than 10 Pa·s, particularly preferably 5 Pa·s. Among the above exemplified resins, a rigid polyurethane resin, a rigid epoxy resin and a crosslinking EVA are particularly preferable. Also, as the second resin 16, it is allowable to use a product commercially offered as a so-called reactive hot melt adhesive.

In the sealing member 14, in consideration of the concavo-convex surface structure of the photovoltaic element 11, it is preferable that the second resin 16 be disposed only at a part where the interfacial peeling from the photovoltaic element 11 is likely to occur. This allows for a decrease in the used amount of the second resin 16. That is, preferably, the used amount of the second resin 16 should be reduced in a range in which the interfacial peeling between the photovoltaic element 11 and the sealing member 14 (hereinafter, referred to as merely "interfacial peeling", also) does not occur. By decreasing the used amount of the second resin 16 having a hydrophilic property in this way, it is possible to decrease the moisture content in the sealing member 14 and enhance the reliability of the photovoltaic module.

As shown in FIG. 2 and FIG. 3, the second resin 16 is provided on concavities 28 of the textured structure 27 that are on a part of the light-receiving surface of the photovoltaic element 11 and on which the interfacial peeling is likely to occur. Preferably, among the concavities 28, the second resin 16 should be provided on concavities 28 positioned around the light-receiving surface electrode 22, on which the interfacial peeling is particularly likely to occur. On the other hand, in terms of suppression of a decrease in reliability caused by moisture contained in the second resin 16, it is preferable not to provide the second resin 16 on a region apart from around the light-receiving surface electrode 22.

Here, the concavity of the textured structure is a recessed part relative to the uppermost part of the surface (the light-receiving surface, the back surface) of the photovoltaic element 11. Preferably, the second resin 16 should be provided so as to fill at least approximately 5% to 50% of the depth of the concavity 28.

In the embodiment of FIG. 3, which is not part of the invention, the second resin 16 is provided on the concavities 28 of the textured structure 27 positioned around the finger portion 24. For example, the second resin 16 can be provided on the light-receiving surface in a thickness not exceeding the thickness of the finger portion 24, while completely sealing the concavities 28 positioned around the finger portion 24.

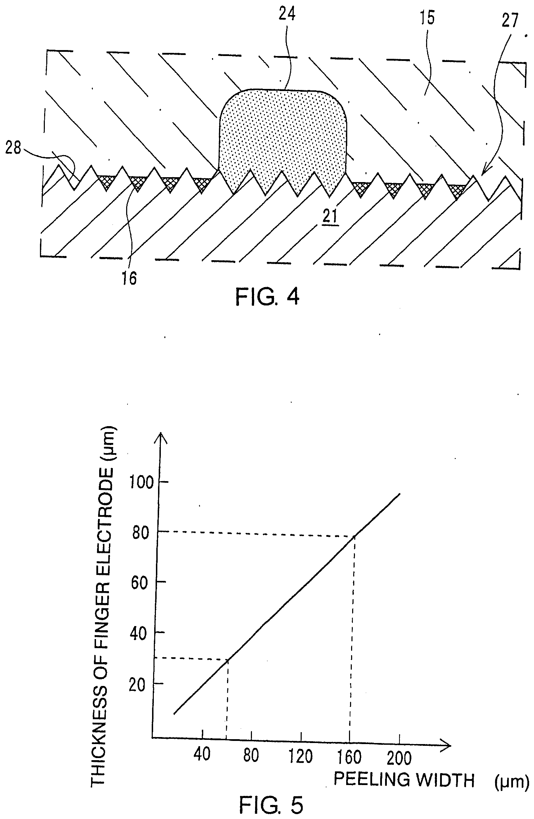

FIG. 4 is an enlarged diagram of part B in FIG. 2 and exemplifies a different embodiment from the example shown in FIG. 3.

In the embodiment exemplified in FIG. 4, the second resin 16 is provided only in the concavities 28 of the textured structure 27 positioned around the finger portion 24. The second resin 16 does not completely fill the concavities 28, and is provided, for example, only at the lowermost parts and vicinities thereof in the concavities 28. The interfacial peeling typically occurs from the lowermost parts of the concavities 28, and therefore, by providing the second resin 16 there, it is possible to efficiently prevent the interfacial peeling. Furthermore, it is possible to substantially decrease the used amount of the second resin 16.

Preferably, the second resin 16 should be provided along the longitudinal direction of the finger portion 24, for example. Also, preferably, the second resin 16 should be provided so as to surround all around the finger portion 24. Alternatively, for further decreasing the used amount of the second resin 16, the second resin 16 may be provided at predetermined intervals along the longitudinal direction of the finger portion 24.

FIG. 5 shows a relationship between a thickness of the finger portion 24 and a width therearound within which the interfacial peeling is likely to occur (referred to as "peeling width"). FIG. 5 shows, as the peeling width, the maximum of the widths from the edge of the finger portion 24 in which the interfacial peeling is recognized, for each thickness of the finger portion 24.

As shown in FIG. 5, the greater the thickness of the finger portion 24 is, the greater the peeling width is. Then, the interfacial peeling is likely to occur in the range corresponding to approximately twice the thickness of the finger portion 24. The relationship shown in FIG. 5 was checked under the following conditions.

Photovoltaic element;
Outermost layer: ITO (indium oxide (In₂O₃) with an additive of tin (Sn))
Thickness of finger portion 24: 20 µm to 100 µm
Average depth of concavities 28 of textured structure 27: approximately 10 µm
Sealing member: polyethylene (PE) with a melting point of 90°C
Checking method: cross-section observation with a scanning electron microscope (SEM)

This relationship was similar for cases where the average depths of the concavities 28 of the textured structures 27 was approximately 1 µm to 15 µm.

That is, it is particularly preferable to provide the second resin 16 from the edge of the finger portion 24 over a range that is around the finger portion 24 and that corresponds to approximately twice the thickness thereof. For example, when the thickness of the finger portion 24 is 50 µm, the second resin 16 is provided from the edge of the finger portion 24 over a range of 100 µm. Preferably, the thickness of the finger portion 24 should be approximately 30 µm to 80 µm, and therefore, preferably, the second resin 16 should be provided from the edge of the finger portion 24 over a range of approximately 60 µm to 160 µm. On the other hand, preferably, the second resin 16 should not be provided from the edge of the finger portion 24 beyond the range corresponding to approximately twice the thickness thereof.

In the embodiment, the first resin 15 and the second resin 16 are also provided on the back surface of the photovoltaic element 11. The second resin 16, which is provided on at least some of the concavities of the textured structure (not shown in the figure) formed on the back surface, improves the adhesion between the back surface of the photovoltaic element 11 and the first resin 15. Particularly, in the case of not intending to receive light from the back surface side, it is preferable to provide the second resin 16 over a wider range than a range over which it is provided on the light-receiving surface.

Next, an example of a production method of the photovoltaic module 10 will be shown.

First, the tabs 17 are attached to the light-receiving surface electrode 22 and back surface electrode 23 of the photovoltaic element 11, and the tabs 17 and the crossover tabs 18 are connected so that the plurality of photovoltaic elements 11 are connected in series. Subsequently, using the first protective member 12, the second protective member 13 and the sealing member 14, the plurality of photovoltaic elements 11 are laminated. Then, the frame 20 and the terminal box are attached.

Preferably, the second resin 16 should be provided on at least a part of the light-receiving surface and back surface of the photovoltaic element 11, before the laminating step. For example, first, an uncured resin solution mixed with a main agent and a curing agent (a crosslinking agent) is applied around the finger portion 24 by a screen printing method or the like. Preferably, the viscosity of the resin solution to be applied should be as low as approximately 5 Pa·s to 30 Pa·s. By using an uncured resin with a low viscosity, the applied resin solution fills the concavities 28 of the textured structure 27. Furthermore, by adjusting the applied amount, the resin solution can fill only the concavities 28. Subsequently, after drying the solvent, the uncured resin is also applied on a predetermined region of the back surface, and is dried. Then, by heat-treating the photovoltaic element 11 (for example, 150°C × 60 minutes) and promoting the crosslinking reaction, it is possible to obtain the photovoltaic element 11 in which the concavities of the textured structure are filled with the heat-cured second resin 16.

In the laminating step, a stacked body is made by overlaying the first protective member 12, a film composed of the first resin 15, the photovoltaic element 11 having the heat-cured second resin 16 on the light-receiving surface and back surface, a film composed of the first resin 15, and the second protective member 13, in this order. Then, for example, in a vacuum state, the stacked body is heated while being compressed, and is unified. The temperature of a hot plate for compressing the laminate is set to greater than or equal to the melting temperature of the first resin 15 (for example, approximately 150°C). As the first protective member 12 and the second protective member 13, it is possible to use, for example, a glass plate with a thickness of approximately 1 to 5 mm, or a resin film (for example, a polyethylene terephthalate (PET) film) with a thickness of approximately 0.1 to 1 mm. As the film of the first resin 15, it is possible to use, for example, a polyolefin film with a thickness of approximately 0.1 to 1 mm.

Here, it is possible to add various kinds of additives such as an antioxidant, an ultraviolet absorber, a durability enhancing agent, a silane coupling agent, a crosslinking auxiliary agent (catalyst), and a tackifier, in the first resin 15 and the second resin 16.

As described above, the photovoltaic module 10 includes the sealing member 14 configured by the first resin 15 with a high hydrophobic property, and the second resin 16 that is provided on the concavities 28 of the textured structure 27 between the photovoltaic element 11 and the first resin 15 and has a higher adhesion strength to the photovoltaic element 11 than the first resin 15. For example, the first resin is a high hydrophobic slightly-crosslinking resin or non-crosslinking resin, and the second resin 16 is a crosslinking resin with a higher hydrophilic property than the first resin 15. According to the configuration, it is possible to sufficiently decrease the used amount of the high hydrophilic crosslinking resin, and as a result to prevent the interfacial peeling between the photovoltaic element 11 and the sealing member 14. It is thus possible to suppress a decrease in reliability due to both moisture content and interfacial peeling. In addition, it is possible to prevent the occurrence of poor appearance.

There is a possibility of the photovoltaic module 10 being exposed to so high a temperature environment that the first resin 15 softens or melts, but by using, as the second resin 16, a crosslinking resin with a higher softening temperature than the first resin 15, it is possible to prevent the interfacial peeling in the high temperature environment. That is, according to the photovoltaic module 10, even when being exposed to a high temperature and high humidity environment for a long time, it is possible to sufficiently suppress a decrease in output power.

In the embodiment, design changes can be made as long as the object of the present invention is not impaired.

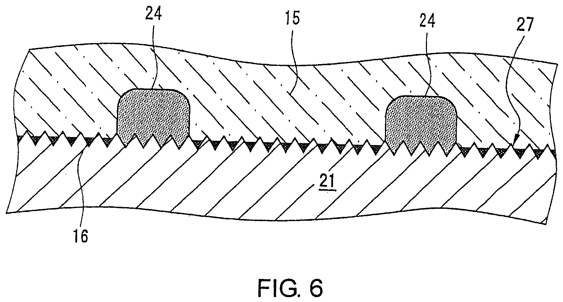

For example, as shown in FIG. 6, the second resin 16 may be provided over the whole range between the finger portions 24 so as to fill the concavities 28 of the textured structure 27 up to approximately one-half of the depth. Alternatively, the second resin 16 may be provided only in the concavities 28 of the textured structure 27, over the whole range on the light-receiving surface of the photovoltaic element 11. The embodiment exemplified in FIG. 6 enhances the adhesion between the photovoltaic element 11 and the first resin 15 by providing the second resin 16 over a wide range on the light-receiving surface, and thereby decreases the used amount of the second resin 16 by providing the second resin 16 only in the concavities 28.

In the embodiment, it has been described that the second resin 16 is provided on the concavities 28 of the textured structure 27 that are positioned around the finger electrode 24. However, the second resin 16 may also be provided on the concavities 28 of the textured structure 27 that are positioned around the bus bar electrode 25.

Furthermore, the sealing member 14 having the first resin 15 and the second resin 16 only has to be provided on at least one of the light receiving surface side and back surface side of the photovoltaic element 11, and it is particularly preferable that it be provided on the light-receiving surface side of the photovoltaic element 11.

### REFERENCE SIGNS LIST

10 photovoltaic module, 11 photovoltaic element, 12 first protective member, 13 second protective member, 14 sealing member, 15 first resin, 16 second resin, 17 tab, 18 crossover tab, 19 output tab, 20 frame, 21 photovoltaic portion, 22 light-receiving surface electrode, 23 back surface electrode, 24, 26 finger portion, 25 bus bar portion, 27 textured structure, 28 concavity

## Claims

1. A photovoltaic module (10) comprising:
a photovoltaic element (11) including a photovoltaic portion (21) and a light-receiving surface electrode (22), the photovoltaic portion (21) having a textured structure (27) on a light-receiving surface, the light-receiving surface electrode (22) being provided on a part of the light-receiving surface, and the light-receiving surface electrode (22) is configured to include a plurality of finger portions (24) and a plurality of bus bar portions (25); and
a sealing member (14) provided on the light-receiving surface of the photovoltaic element (11) and including a first resin (15) and a second resin (16), the first resin (15) having a higher hydrophobic property than the second resin (16),
**characterized in that** the second resin (16) is provided only in the concavities (28) of the textured structure (27) positioned around a finger portion (24) or positioned around a bus bar portion (25) between the light-receiving surface and the first resin (15) and does not completely fill the concavities (28), and has a higher adhesion strength to the photovoltaic element (11) than the first resin (15).

2. The photovoltaic module (10) according to claim 1,
wherein the second resin (16) is provided from an edge of the light-receiving surface electrode (22) over a range corresponding to approximately twice a thickness thereof.

3. The photovoltaic module (10) according to any one of claims 1 or 2,
wherein the second resin (16) has a higher softening temperature than the first resin (15).

4. The photovoltaic module (10) according to any one of claims 1 to 3,
wherein the photovoltaic portion (21) has a back surface textured structure on a back surface,
the photovoltaic module (10) comprises a back surface sealing member disposed on the back surface of the photovoltaic portion (21),
the back surface sealing member is configured to include a first back surface resin (15) and a second back surface resin (16),
the first back surface resin (15) has a higher hydrophobic property than the second back surface resin (16),
the second back surface resin (16) is provided on at least some of concavities of the back surface textured structure between the back surface and the first back surface resin (15), and has a higher adhesion strength to the back surface than the first back surface resin (15), and
the second back surface resin (16) is provided on at least some of the concavities of the back surface textured structure, over a wider range than a range of the second resin (16) provided on the light-receiving surface.

## Patentansprüche

1. Photovoltaik-Modul (10), aufweisend:
ein Photovoltaik-Element (11) mit einem Photovoltaik-Abschnitt (21) und einer Licht empfangende Oberflächenelektrode (22), wobei der Photovoltaik-Abschnitt (21) eine Textur-Struktur (27) auf einer Licht empfangenden Oberfläche aufweist, wobei die Licht empfangende Oberflächenelektrode (22) auf einem Teil der Licht empfangende Oberfläche bereitgestellt ist, und wobei die Licht empfangende Oberflächenelektrode (22) mit einer Vielzahl von Finger-Abschnitten (24) und einer Vielzahl von Sammelschienen-Abschnitten (25) konfiguriert ist; und
ein Dichtungsglied (14), welches auf der Licht empfangende Oberfläche des Photovoltaik-Elements (11) vorgesehen ist und ein erstes Harz (15) und ein zweites Harz (16) aufweist, wobei das erste Harz (15) stärker wasserabweisend ist als das zweite Harz (16),
**dadurch gekennzeichnet, dass** das zweite Harz (16) nur in den Höhlungen der Textur-Struktur (27) um einen Finger-Abschnitt (24) herum oder um einen Sammelschienen-Abschnitt (25) herum zwischen der Licht empfangende Oberfläche und dem ersten Harz (15) vorgesehen ist und die Höhlungen (28) nicht vollständig ausfüllt und eine stärker an dem Photovoltaik-Element (11) als dem ersten Harz (15) haftet.

2. Photovoltaik-Modul (10), gemäß Anspruch 1,
wobei das zweite Harz (16) ausgehend von einem Rand der Licht empfangende Oberflächenelektrode (22) über einen Bereich entsprechend annähernd dem Zweifachen seiner Dicke vorgesehen ist.

3. Photovoltaik-Modul (10), gemäß einem der Ansprüche 1 oder 2,
wobei das zweite Harz (16) eine höhere Erweichungstemperatur als das zweite Harz (15) aufweist.

4. Photovoltaik-Modul (10), gemäß einem der Ansprüche 1 bis 3,
wobei der Photovoltaik-Abschnitt (21) eine Rückseiten-Textur-Struktur auf einer Rückseite aufweist,
das Photovoltaik-Modul (10) ein Rückseitendichtungsglied, welches auf der Rückseite des Photovoltaik-Abschnitts (21) angeordnet ist, aufweist,
das Rückseitendichtungsglied konfiguriert ist, ein erstes Rückseitenharz (15) und ein zweites Rückseitenharz (16) aufzuweisen,
das erste Rückseitenharz (15) eine stärker wasserabweisend ist als das zweite Rückseitenharz (16),
das zweite Rückseitenharz (16) auf wenigstens einigen der Höhlungen der Rückseiten-Textur-Struktur zwischen der Rückseite und dem ersten Rückseitenharz (15) vorgesehen ist und stärker an der Rückseite haftet an dem ersten Rückseitenharz (15), und
das zweite Rückseitenharz (16) auf wenigstens einigen der Höhlungen der Rückseiten-Textur-Struktur über einen breiteren Bereich als einen Bereich des zweiten Harzes (16), welches auf der Licht empfangenden Oberfläche vorgesehen ist, vorgesehen ist.

## Revendications

1. Module photovoltaïque (10) comprenant :
un élément photovoltaïque (11) comprenant une partie photovoltaïque (21) et une électrode de surface de réception de lumière (22), la partie photovoltaïque (21) ayant une structure texturée (27) sur une surface de réception de lumière, l'électrode de surface de réception de lumière (22) étant prévue sur une partie de la surface de réception de lumière, et l'électrode de surface de réception de lumière (22) est configurée pour comprendre une pluralité de parties de doigt (24) et une pluralité de parties de barre omnibus (25) ; et
un élément d'étanchéité (14) prévu sur la surface de réception de lumière de l'élément photovoltaïque (11) et comprenant une première résine (15) et une seconde résine (16), la première résine (15) ayant une propriété hydrophobe supérieure à la seconde résine (16),
**caractérisé en ce que** la seconde résine (16) est prévue uniquement dans les concavités (28) de la structure texturée (27) positionnée autour de la partie de doigt (24) ou positionnées autour d'une partie de barre omnibus (25) entre la surface de réception de lumière et la première résine (15) et ne remplit pas complètement les concavités (28), et a une résistance à l'adhérence sur l'élément photovoltaïque (11) supérieure à la première résine (15).

2. Module photovoltaïque (10) selon la revendication 1,
dans lequel la seconde résine (16) est prévue à partir d'un bord de l'électrode de surface de réception de lumière (22) sur une plage correspondant approximativement à deux fois son épaisseur.

3. Module photovoltaïque (10) selon l'une quelconque des revendications 1 ou 2,
dans lequel la seconde résine (16) a une température de ramollissement supérieure à la première résine (15).

4. Module photovoltaïque (10) selon l'une quelconque des revendications 1 à 3,
dans lequel la partie photovoltaïque (21) a une structure texturée de surface arrière sur une surface arrière,
le module photovoltaïque (10) comprend un élément d'étanchéité de surface arrière disposé sur la surface arrière de la partie photovoltaïque (21),
l'élément d'étanchéité de surface arrière est configuré pour comprendre une première résine de surface arrière (15) et une seconde résine de surface arrière (16),
la première résine de surface arrière (15) a une propriété hydrophobe supérieure à la seconde résine de surface arrière (16),
la seconde résine de surface arrière (16) est prévue sur au moins certaines des concavités de la structure texturée de surface arrière entre la surface arrière et la première résine de surface arrière (15), et a une résistance à l'adhérence sur la surface arrière supérieure à la première résine de surface arrière (15), et
la seconde résine de surface arrière (16) est prévue sur au moins certaines des concavités de la structure texturée de surface arrière sur une plage plus large qu'une plage de la seconde résine (16) prévue sur la surface de réception de lumière.
